# EUROPÄISCHE PATENTSCHRIFT

(11) **EP 2 880 967 B1**
(45) Veröffentlichungstag und Bekanntmachung des Hinweises auf die Patenterteilung: **23.09.2020**
(21) Anmeldenummer: 13728714.0
(22) Anmeldetag: 10.06.2013
(51) Int. Cl.: H05K 3/00, H05K 3/28, H05K 5/00, H05K 5/06, G01P 1/02, G01D 11/24

(54) **BAUELEMENTE-UMMANTELUNG FÜR EIN ELEKTRONIKMODUL**
COMPONENT CASING FOR AN ELECTRONIC MODULE
ENVELOPPE DE COMPOSANTS POUR UN MODULE ÉLECTRONIQUE

(30) Priorität: 06.08.2012 DE 102012213917
(43) Veröffentlichungstag der Anmeldung: 10.06.2015
(73) Patentinhaber: Robert Bosch GmbH, 70442 Stuttgart (DE)
(72) Erfinder: OTT, Harald, 71691 Freiberg Am Neckar (DE); BERGER, Torsten, 71686 Remseck Am Neckar (DE); KAMMER, Gerald, 71640 Ludwigsburg (DE)
(86) Internationale Anmeldenummer: PCT/EP2013/061899
(87) Internationale Veröffentlichungsnummer: WO 2014/023457

(56) Entgegenhaltungen:
- WO-A1-2005/088709
- DE-A1- 10 207 777
- DE-A1-102010 030 170
- US-A1- 2002 170 897
- US-A1- 2007 252 249
- US-A1- 2008 170 372

## Beschreibung

Die vorliegende Erfindung betrifft Elektronikmodule für Fahrzeugsteuergeräte. Insbesondere betrifft die vorliegende Erfindung eine Bauelement-Ummantelung für Elektronikmodule für ein Steuergerät eines Fahrzeugs. Weiter insbesondere betrifft die vorliegende Erfindung ein Elektronikmodul, ein Steuergerät, ein Fahrzeug, insbesondere ein Automobil, sowie ein Herstellungsverfahren für ein Elektronikmodul, aufweisend eine Bauelemente-Ummantelung.

### Stand der Technik

Elektronikmodule für Steuergeräte, zum Beispiel für Getriebesteuergeräte, benötigen meist aufgrund ihrer Anordnung, zum Beispiel in einer aggressiven Flüssigkeit, meist ein hermetisch dichtes Gehäuse. Herkömmliche Elektronikmodule realisieren dies, indem auf einer Leiterplatte ein Abdeckelement aufgebracht, beispielsweise aufgeklebt wird. Das Abdeckelement kann z.B. metallisch ausgeführt sein, während die Leiterplatte herkömmlich ausgebildet ist.

Wichtig für eine gute Abdichtung des durch die Leiterplatte und das Abdeckelement gebildeten Innenraums ist eine geeignete Klebeverbindung zwischen dem Abdeckelement und der Leiterplatte. An eine solche Klebeverbindung können besondere Anforderungen gestellt sein. Wird beispielsweise ein Elektronikmodul als Bestandteil eines Getriebesteuergerätes im Getriebe eingesetzt, kommt dieses regelmäßig mit aggressiver Getriebeflüssigkeit in Berührung. Darüber hinaus erfährt ein solches Elektronikmodul im Betrieb regelmäßig eine starke Erwärmung. Eine Klebeverbindung muss somit auch im Falle eines erwärmten Betriebes sicher abdichten. Insbesondere unterschiedliche Wärmeausdehnungskoeffizienten der Materialien von Leiterplatte und Abdeckelement können in der Klebeverbindung Scherkratte hervorruten.

Relevante Elektronikmodule sind zum beispiel aus der DE 10 2010 030170 A1 oder der WO 2005/088709 A1 bekannt. Das in der WO 2005/088709 offenbarte Elektronikmodul weist ein Leiterplattenelement mit zumindest einem elektronischen Bauelement und einem Mantelelement auf, wobei das Mantelelement mit dem Leiterplattenelement verbunden ist und wobei das zumindest eine elektronische Bauelement zwischen Mantelelement und Leiterplattenelement angeordnet ist und wobei das Mantelelement einen Innenraum ausbildet und das zumindest eine elektronische Bauelement im Innenraum angeordnet ist und wobei das Mantelelement als ein Rahmenelement ausgebildet ist und das Elektronikmodul ein Abdeckelement aufweist, welches zusammen mit dem Rahmenelement das Mantelelement ausbildet und den Innenraum für das zumindest eine elektronische Bauelement aufweist.

### Offenbarung der Erfindung

Ein Aspekt der vorliegenden Erfindung kann somit darin gesehen werden, eine verbesserte Bauelemente-Ummantelung für Bauelemente eines Elektronikmoduls bereitzustellen. Das erfindungsgemäße Elektronikmodul und ein entsprechendes Herstellungsverfahren sind in den unabhängigen Ansprüchen 1 und 8 definiert.

Demgemäß wird ein Elektronikmodul für ein Fahrzeug, ein Steuergerät für ein Fahrzeug, ein Fahrzeug, insbesondere ein Automobil, sowie ein Herstellungsverfahren für ein Elektronikmodul gemäß den unabhängigen Ansprüchen bereitgestellt. Bevorzugte Ausgestaltungen ergeben sich aus den abhängigen Ansprüchen.

Erfindungsgemäß wird ein Elektronikmodul angezeigt, welches zunächst ein Leiterplattenelement aufweist. Dieses Leiterplattenelement weist zumindest in einem Teilbereich zumindest ein elektronisches Bauelement auf, welches mit dem Leiterplattenelement, insbesondere dessen Leiterbahnen in Verbindung steht. Diese Leiterbahnen können beispielsweise vom elektronischen Bauelement ausgehend im Inneren des Leiterplattenelementes geführt und an entfernter Stelle dieses wiederum verlassen, um beispielsweise elektrische Verbindungstechnik wie Sensorik oder Aktuatorik anzubinden.

Erfindungsgemäß wird nun das zumindest eine elektronische Bauelement von einem Mantelelement umschlossen. Das Mantelelement weist hierbei einen Innenraum auf, in welchem Innenraum das zumindest eine elektronische Bauelement angeordnet ist. Der Innenraum zwischen Mantelelement und Leiterplattenelement kann im Wesentlichen dem elektronischen Bauelement entsprechen, dieses kann somit beispielsweise vom Mantelelement umgossen worden sein, oder aber das Mantelelement selbst kann einen größeren Innenraum aufweisen, somit beispielsweise einen Hohlraum ausbilden, in dem das zumindest eine elektronische Bauelement oder auch eine Vielzahl von elektronischen Bauelementen angeordnet ist.

Das Mantelelement ist nun erfindungsgemäß nicht (ausschließlich) kraftschlüssig an das Leiterplattenelement angebunden, sondern (zumindest partiell) formschlüssig.

Ein entsprechender Formschluss wird sich erfindungsgemäß dadurch bereit gestellt, dass das Leiterplattenelement vor dem Aufbringen des Mantelelementes eine dreidimensionale Mikrostruktur zumindest eines Teilbereiches aufweist, in welchem auch das Mantelelement angeordnet ist. Eine solche Mikrostruktur des Leiterplattenelementes lässt sich beispielsweise durch eine Behandlung des Leiterplattenelementes erzeugen. In anderen Worten wird eine geringfügige, gewollte, nicht reversible Veränderung der Oberfläche des Leiterplattenelementes durch beispielsweise einen Laserstrahl erzeugt, wodurch die Oberfläche in dem Bereich der Mikrostrukturierung eine solche Oberfläche aufweisen kann, die geeignet ist, einem Mantelelement, welches beispielsweise nach der Erzeugung der Mikrostruktur aufgespritzt wird, eine ausreichende Basis für eine formschlüssige Verankerung auf der Oberfläche bereitzustellen. Anders ausgedrückt kann über die Laserbehandlung die Oberfläche partiell und minimal zerstört bzw. aufgeraut werden, so dass ein nachträglich aufgespritztes Kunststoffteil mit dieser Oberfläche einen Formschluss ausbilden kann.

Ein Leiterplattenelement erhält somit zumindest partiell durch eine Laserbehandlung oder einen anderen geeigneten Umformprozess eine Mikrostruktur seiner Oberfläche. Nachfolgend wird in einem Spritzprozess eine Kunststoffmasse fest haftend und dicht, zumindest partiell mit dem Leiterplattenelement verbunden. Aufgrund der Mikrostrukturierung stellt somit die Oberfläche des Leiterplattenelementes in diesem Bereich eine geeignete Oberfläche zur Verfügung, um sich mit einem nachfolgend aufgespritzten Kunststoffmaterial formschlüssig zu verbinden.

Eine solche erfindungsgemäße Mikrostrukturierung stellt somit eine kostengünstige und einfache Möglichkeit der Realisierung einer Verbindung zwischen einem Leiterplattenelement und einem Kunststoff dar. Dies ermöglicht neue Abdichtkonzepte zwischen Leiterplattenelement und Kunststoff. Bekannte Leiterplattenelemente haben dabei eine hohe Temperaturbeständigkeit und sind somit für einen Kunststoffumspritzprozess geeignet. Ein separater Oberflächenreinigungsprozess, wie beispielsweise vor einem Verkleben von Elementen, kann entfallen, insbesondere dann, wenn direkt nach dem Oberflächenstrukturierungsvorgang das Mantelelement aufgespritzt wird. Erfindungsgemäß kann als Leiterplattenelement eine herkömmliche Leiterplatte oder aber auch eine flexible Leiterplatte (Flexible Printed Circuit FPC) verwendet werden. Auch denkbar ist, beispielsweise eine auf der Oberfläche des Leiterplattenelementes verlaufende Leiterbahn zu mikrostrukturieren. Hierbei kann eine Anpassung des Mikrostrukturierungsprozesses nötig sein, beispielsweise Anpassung der Leistung eines Laserstrahls.

Ebenso kann in Rahmen der vorliegenden Erfindung unter einer Leiterplatte allgemein ein Schaltungsträger verstanden werden, der an der Oberfläche eine partielle Mikrostruktur besitzt und z.B. integrierte oder zumindest partiell an der Oberfläche verlaufendende, metallische Leiter aufweist. Dies mag beispielsweise ein Thermo- oder Duroplast (verstärkt oder unverstärkt) mit eingebetteten bzw. eingespritzten metallischen Leitern, z.B. eine PCB oder FPC mit integrierten Leitern, ein Kunststoffteil mit integrierten Stanzgittern oder Drähten als Leiter oder auch ein keramischer Schaltungsträger sein. Der Ausdruck Leiterplatte soll somit im Kontext der vorliegenden Erfindung nicht einschränkend als ein Element aus gehärtetem Epoxidharz mit integrierten Glasfasermatten aufgefasst werden. Dies stellt somit lediglich ein exemplarisches Beispiel dar, auf welches die nachfolgende Figurenbeschreibung Bezug nimmt.

Ausführungsformen der Erfindung sind in den Zeichnungen dargestellt und in der nachfolgenden Beschreibung näher erläutert.

Es zeigen
- Figuren 1a,b: das erfindungsgemäße Prinzip der Mikrostrukturierung;
- Figuren 2a-c: ein exemplarisches Verfahren zur Mikrostrukturierung;
- Figuren 3a-8c: exemplarische Ausgestaltungen eines Elektronikmoduls.

### Ausführungsformen der Erfindung

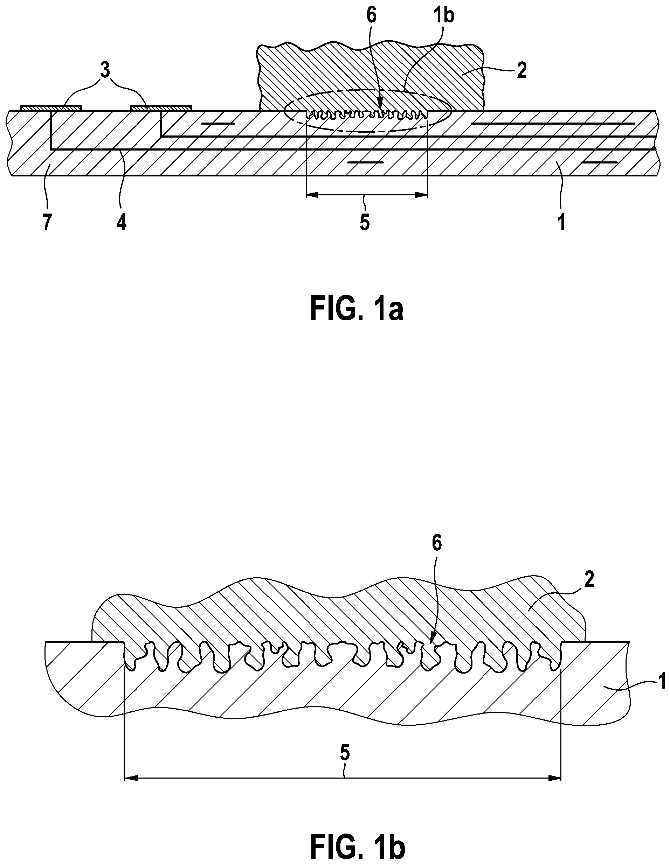

Weiter Bezug nehmend auf die Figuren 1a,b wird das erfindungsgemäße Prinzip der Mikrostrukturierung dargestellt.

In Figur 1a zu sehen ist zunächst ein Leiterplattenelement 7, exemplarisch ausgeführt aus gehärtetem Epoxidharz mit integrierten Glasfasermatten.

Zumindest teilweise im Inneren des Leiterplattenelementes 7 angeordnet sind Leiterelemente 4, beispielsweise ausgeführt als Kupferleiter, welche an einer definierten Stelle durch die Oberfläche des Leiterplattenelementes 4 ragen und dort beispielsweise unter Verwendung von Kontaktelementen 3 bzw. Kontaktpads abgeschlossen sind. Die Kontaktelemente 3 können unterschiedliche Oberflächenbeschichtungen aufweisen, beispielsweise Gold oder Zinn.

Die Oberfläche des Leiterplattenelementes 7 wird in einem definierten Bereich 5 oberflächenbehandelt und dabei mikrostrukturiert 6. Die Mikrostruktur 6 kann exemplarisch mit einem Laserprozess generiert werden, bei welchem ein Laserstrahl auf die Oberfläche aufgebracht wird. Die Mikrostrukturierung 6 kann dabei partiell erfolgen, somit nur einen Teil der Oberfläche eines Leiterplattenelementes 7 betreffen und insbesondere umlaufend sein, somit exemplarisch ein auf der Oberfläche angeordnetes elektronisches Bauelement umfangsseitig umschließen. Hierdurch mag sichergestellt sein, dass das Bauelement von einem sicher auf der Oberfläche des Leiterplattenelementes haftenden Mantelelement, welches auf die Mikrostrukturierung 6 aufgebracht wird, umschlossen werden kann.

In einem nach dem Mikrostrukturierungsschritt nachgeschalteten Umspritzprozessschritt kann im Bereich 5 ein Mantelelement 2, beispielsweise ausgebildet als eine Kunststoffmasse 2 angeordnet bzw. aufgespritzt werden. Diese Kunststoffmasse kann exemplarisch ein Thermoplast oder Duroplast sein, das mit seinem Wärmeausdehnungskoeffizienten, gegebenenfalls durch Verwendung passender Füll- bzw. Verstärkungsstoffe an den Wärmeausdehnungskoeffizienten des Leiterplattenelementes 7 angepasst ist.

Das Mantelelement 2 kann dabei den Bereich 5 umspritzen bzw. im Bereich der Mikrostrukturierung 6 nur überspritzt werden. So kann beispielsweise ein geeignetes Aufnahmemittel fest mit der Leiterplattenelementoberfläche verbunden werden, welches nachfolgend geeignet bzw. eingerichtet ist, weitere Elemente, beispielsweise zur Abdeckung bzw. hermetischen Versiegelung von Bauelementen auf dem Leiterplattenelement 7 bereitzustellen.

Bei dem Spritzprozess dringt die zumindest teilweise flüssige Masse des Mantelelementes, beispielsweise eine flüssige Kunststoffmasse, in die Mikrostrukturen 6 des Leiterplattenelementes 7 ein und füllt dieses aus. Beim anschließenden Erkalten kommt es zu einer festen und dichten Verbindung zwischen Mantelelement 2 und Mikrostrukturierung 6. Aufgrund der Ausgestaltung der Mikrostrukturierung 6, wie beispielsweise der Figur 1b zu entnehmen ist, verbinden sich Mantelelement 2 und Mikrostrukturierung 6 formschlüssig.

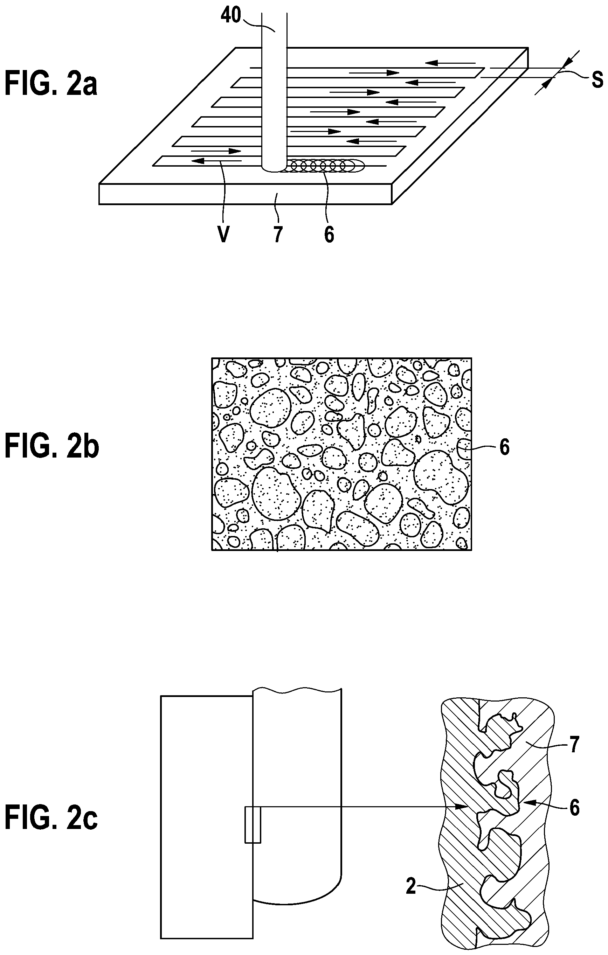

Weiter Bezug nehmen auf Figuren 2a-c wird ein exemplarisches Verfahren zur Mikrostrukturierung dargestellt.

Figur 2a zeigt exemplarisch ein Leiterplattenelement 7. Figur 2a kann hierbei einen Ausschnitt aus einer größeren Leiterplatte versinnbildlichen. Exemplarisch wird ein Mikrostrukturierungsverfahren angezeigt, bei dem ein Laserstrahl 40 die Oberfläche des Leiterplattenelementes 7 überstreicht und hierbei die Mikrostrukturierung 6 erzeugt. Exemplarisch fährt Laserstrahl 40 linear in Richtung V und erzeugt dabei eine mikrostrukturierte Bahn der Breite S.

Nach Durchfahren einer Bahn kann beispielsweise die Bewegungsrichtung des Laserstrahls invertiert werden und direkt neben dieser nun erzeugten Bahn eine weitere Bahn mikrostrukturiert werden. Durch mehrfaches Überstreichen der Oberfläche des Leiterplattenelementes 7 kann somit eine wie in Figur 2b dargestellte Oberfläche erzeugt werden. Diese weist eine Mikrostrukturierung 6 auf, auf die nun in einem nachfolgendem Spritzprozess eine geeignete Kunststoffmasse oder dergleichen, allgemein ein Mantelelement 2 aufgebracht und mit der mikrostrukturierten Oberfläche verbunden wird. Figur 2c zeigt hierbei nochmals im Detail das Einfließen des Materials des Mantelelementes 2 in die mikrostrukturierte 6 Oberfläche des Leiterplattenelementes 7 und die daraus resultierende formschlüssige Verbindung.

Der Laserstrahl strukturiert somit die Oberfläche durch eine definierte Ablenkung des Laserstrahls, z.B. unter Verwendung eines Galvo-Scanners. Die Oberfläche des Leiterplattenelementes kann dabei mir ultrakurzes Laserpulsen abgerastert werden, wodurch eine Mikro-Nano-Struktur erzeugt wird. Nachfolgend werden die Bauelemente mit einem Thermoplast oder Klebemittel umspritzt. Das Polymer bzw. der Klebstoff dringt bzw. fließt dabei in die mehrskalige Struktur ein und erzeugt dabei eine feste und dichte Verbindung.

Anstatt einer (steifen) Leiterplatte kann das Leiterplattenelement 7 auch als flexible Leiterplatte bzw. Flexible Printed Circuit Board (FPCB) realisiert sein. Gegebenenfalls muss die Leistung eines für die Mikrostrukturierung 6 verwendeten Lasers an die Folienstruktur der flexiblen Leiterplatte angepasst werden.

Im Weiteren werden einige technische Umsetzungen beschrieben, die beispielhaft in Getriebesteuermodulen, deren Steuergerät und deren Funktionselementen zum Einsatz kommen können.

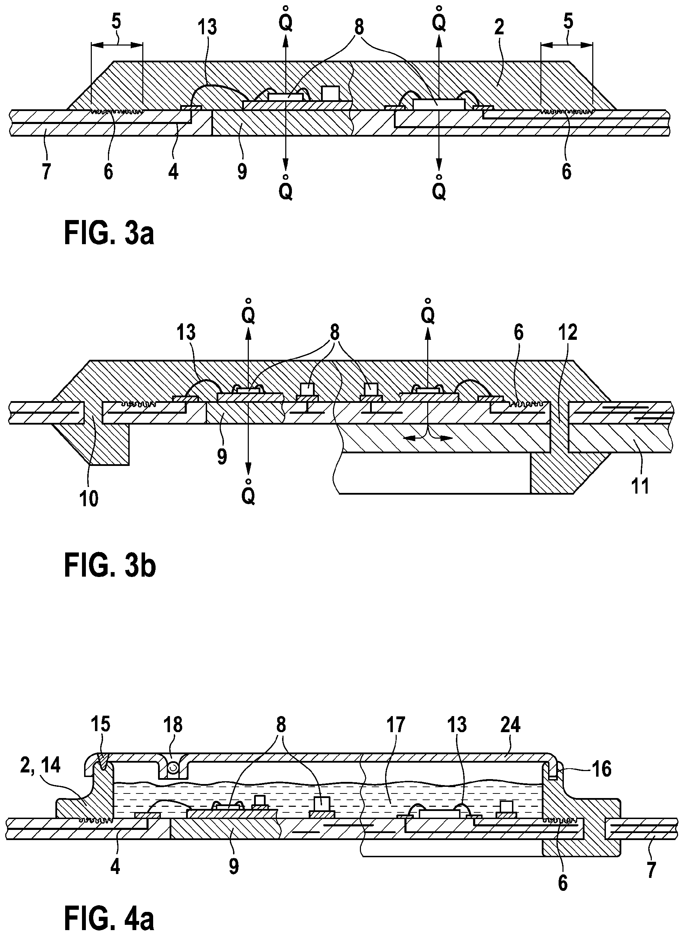

Die in den Figuren 3a und 3b gezeigten Ausgestaltungen eines Elektronikmoduls dienen illustrativen Zwecken und fallen nicht unter den beanpruchten Gegenstand.

Figur 3a zeigt eine exemplarische Ausgestaltung eines Elektronikmoduls mit dichter Mold-Verpackung, welche direkt auf das Leiterplattenelement 7 aufgespritzt ist.

Eine Oberfläche des Leiterplattenelementes 7 ist wiederum durch einen Laser partiell und umlaufend mikrostrukturiert 6 worden. Auf der Oberfläche angeordnet sind elektronische Bauelemente 8, die beispielsweise unter Verwendung von Verbindungselementen bzw. Bonds 13 mit Kontaktflächen 3 und im Weiteren den Leitelementen 4 verbunden sind. Diese auf der Oberfläche des Leiterplattenelementes 7 angeordneten Bauelemente 8 sollen nun im Weiteren durch den erfindungsgemäßen Ummantelungsprozess geschützt werden. Unter Verwendung eines geeigneten Umspritzwerkzeuges wird somit Mantelelement 2, zunächst in Form exemplarisch als flüssige Kunststoffmasse, auf das Leiterplattenelement 7 und hierbei insbesondere auf den Bereich 5 der Mikrostrukturierung 6 aufgebracht. Diese Mikrostrukturen 6 werden somit mit der Kunststoffmasse 2 gefüllt und überdecken dabei die Bauelemente 8. Somit ergibt sich nach dem Erkalten der Kunststoffmasse 2 ein dichter Schutz der elektronischen Bauelemente 8 zum Beispiel vor Getriebeöl.

Leiterplattenelement 7 kann hierbei, wie in Figur 3a dargestellt, an geeigneter Stelle ein Wärmeleitelement 9, zum Beispiel ein Metallinlay aus Kupfer, aufweisen, um hierdurch eine verbesserte Wärmeabfuhr Q der elektronischen Bauelemente 8 bereitzustellen.

Figur 3b zeigt nun eine Mold-Verpackung, welche partiell durch das Leiterplattenelement 7 gespritzt wurde.

Figur 3b ist hierbei im Wesentlichen mit Figur 3a vergleichbar, wobei das Leiterplattenelement 7 an geeigneter Stelle Aussparungen 10,12 aufweist. Durch geeignet ausgebildete Werkzeuge kann die Moldmasse 2 beim Vergießen die Aussparungen 10,12 durchdringen und auf die zweite Seite, in Figur 3b die untenliegende Seite, des Leiterplattenelementes 7 gelangen. Durch geeignete Vergusswerkzeuge kann auf dieser gegenüberliegenden Seite eine Form in die Kunststoffmasse 2 eingebracht werden, so dass auch an der gegenüberliegenden Seite ein Formschluss auftritt. Hierdurch lässt sich ein besserer mechanischer Kontakt bzw. eine verbesserte Befestigung einer erkalteten Moldmasse 2 bereitstellen. Ein Ausgestaltung gemäß Figur 3b mag auch ein Durchbiegen des Elektronikmoduls reduzieren, da die Kunststoffmasse 2 auf beiden Seiten des Leiterplattenelementes auftritt und so für ein Spannungsgleichgewicht sorgt.

Ebenfalls in Figur 3b dargestellt ist die Realisierung eines integrierten Metallinlays 9 im Leiterplattenelement 7. Auf der rechten Seite der Figur 3b ist zusätzlich zum Leiterplattenelement 7 ein Trägerelement 11, beispielsweise eine Metallplatte, vorgesehen, die ebenfalls eine Aussparung 12 aufweist, so dass die Moldmasse 2 sowohl das Leiterplattenelement als auch das Trägerelement 11 durchfließen und dieses von der in Figur 3b untenliegenden Seite her formschlüssig umgreifen kann.

Ein Aspekt der Figuren 3a,b ist die Ummoldung der elektronischen Bauelemente 8 nach deren Montage und Kontaktierung. Ist dies nicht erwünscht, können die nachfolgenden Ausführungsbeispiele Vorteile eines einfachen Steuergerätegehäusekonzepts realisieren, welches Schritt für Schritt aufgebaut und zum Beispiel bei Analyse einfach demontiert werden kann, ohne die Moldmasse 2 bzw. das Mantelelement 2 kompliziert abtragen zu müssen.

Figuren 4a-e zeigen nun ein erfindungsgemäßes Elektronikmodul mit einer Rahmenstruktur.

In Figur 4a zu erkennen ist die Oberfläche des Leiterplattenelementes 7 wiederum mikrostrukturiert 6 ausgebildet. Auf diese Mikrostrukturierung 6 wird nun eine rahmenförmige Struktur 14 aufgebracht, beispielsweise aufgespritzt und dabei in bekannter Weise wie zuvor beschrieben mit der Mikrostrukturierung 6 formschlüssig verbunden. Ein Thermoplast oder Duroplast dringt dabei in die Mikrostrukturen 6 des Leiterplattenelementes 7 ein und ergibt nach dem Erkalten einen zum Leiterplattenelement 7 dichtend ausgebildeten Rahmen 14, aufgebaut aus Mantelelement 2 bzw. dessen Vergussmasse. Wiederum exemplarisch dargestellt ist das teilweise Durchdringen des Mantelelementes 2 durch eine geeignete Öffnung im Leiterplattenelement 7.

Nach dem Aufbringen der Rahmenstruktur 14 auf bzw. durch das Leiterplattenelement 7 und dessen Mikrostruktur 6 kann ein Bestückungsvorgang des Leiterplattenelementes 7 erfolgen, das Leiterplattenelement 7 somit mit elektrischen Bauelementen oder Bauelementeträgern 8 bestückt werden. Die elektrische Verbindung zum im Leiterplattenelement 7 angeordneten Leiterelementen 4 kann wieder durch Verbindungselemente 13 erfolgen.

Zur Abdichtung des Elektronikmoduls, insbesondere des Mantelelementinnenraumes bzw. der dort angeordneten elektronischen Bauelemente 8 gegenüber dem Außenbereich kann ein Abdeckelement 24, bevorzugt aus einem Kunststoff oder Metall, insbesondere einem gleich oder ähnlich ausgebildeten Kunststoff wie die Rahmenstruktur 14, aufgesetzt und wie im Bereich 15 der Figur 4a dargestellt mit beispielsweise einer Ultraschall-Kunststoffschweißung oder einer Laser-Kunststoffschweißung dicht mit dem Gehäuserahmen bzw. der Rahmenstruktur 14 verbunden werden. Allgemein kann 15 als ein beliebiger, geeigneter Schweißvorgang oder anders gearteter Verbindungsprozess ausgestaltet sein.

Eine alternative Verbindungsmöglichkeit ist im Bereich 16 dargestellt und als eine in der Rahmenstruktur 14 verlaufende Nut ausgebildet, in die das Abdeckelement 24 geeignet eingebracht werden, beispielsweise dort dicht verklebt bzw. vergossen werden kann. Abdeckelement 24 kann im Weiteren auch eine Öffnung 18 aufweisen. Mittels dieser Öffnung 18 kann, nachdem das Abdeckelement 24 dicht mit dem Rahmenelement 14 verbunden wurde, eine Dichtheitsprüfung dergestalt durchgeführt, somit geprüft werden, inwieweit der Innenraum des Elektronikmoduls dicht ist. Nach erfolgter Dichtigkeitsprüfung kann gegebenenfalls je nach Applikation ein Vergussmasse 17, beispielsweise ein Gel eingefüllt werden, welches den Innenraum partiell oder vollständig ausfüllt. Öffnung 18 kann auf bekannte Weise mit einem geeigneten Element dicht verschlossen werden, beispielsweise mit einem kugelförmigen Element, welches in Öffnung 18 eingepresst wird.

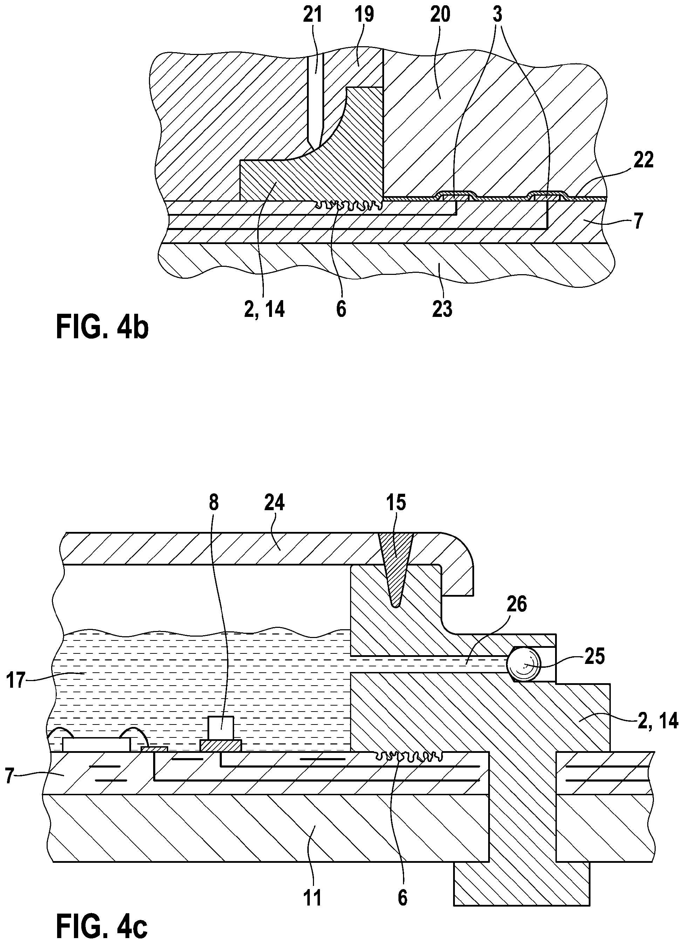

Um bei einem Spritzvorgang der Rahmenstruktur 14 möglicherweise empfindliche und an der Oberfläche des Leiterplattenelementes liegende Kontaktierungsoberflächen 3 nicht zu beschädigen bzw. zu verschmutzen, kann die Oberfläche des Leiterplattenelementes vor dem Spritzvorgang zumindest partiell mit einer geeigneten Abdeckung versehen werden, beispielsweise eine selbstklebende und wärmebeständige Schutzfolie 22. Diese kann exemplarisch aus Polyimid gefertigt sein und nach dem Spritzvorgang und vor dem Bestücken mit elektronischen Bauelementen 8 wieder entfernt werden. Exemplarisch dargestellt sind Werkzeugbestandteile 19,20 und 23, die eine Kavität ausbilden, welche im Wesentlichen der Form der Rahmenstruktur 14 entspricht. Eine geeignete Öffnung, zum Beispiel Anspritzkanal 21, kann vorgesehen sein, um das Material für die Rahmenstruktur 14 in die gebildete Kavität einzubringen. Dies ist exemplarisch in Figur 4b dargestellt.

Gemäß Figur 4c kann wiederum ein Trägerelement 11, beispielsweise eine metallische Trägerplatte, in den Aufbau integriert werden. Das Material des Mantelelementes bzw. der Rahmenstruktur 14 kann nun über geeignete und zueinander angeordnete Öffnungen im Leiterplattenelement 7 sowie im Trägerelement 11 beide zumindest partiell durchdringen und auf der den Bauelementen 8 gegenüberliegenden Seite formschlüssig verbinden. Das metallische Trägerelement 11 ermöglicht auch eine verbesserte Wärmeabfuhr, insbesondere in Kombination mit Metallinlay 9. Trägerelement 11 kann somit generell als eine Wärmesenke angesehen werden.

Mantelelement 2 bzw. Rahmenstruktur 14 kann gemäß Figur 4c eine Öffnung aufweisen, beispielsweise eine zum Leiterplattenelement 7 parallel ausgeführte Prüfbohrung 26 im Gehäuserahmen 14. Die Funktion dieser Prüfbohrung 26 kann vergleichbar der Öffnung 18 sein. Auch hier kann nach einem vollständigen Aufbau des Elektronikmoduls ein Füllmaterial 17, beispielsweise ein Gel in das Innere des Elektronikmoduls eingefüllt werden. Die Prüfbohrung 26 kann wiederum mit einem geeigneten Verschlusselement, zum Beispiel einer in das Kunststoffmaterial des Rahmenelementes 14 eingepresste Kugel 25, dicht verschlossen werden.

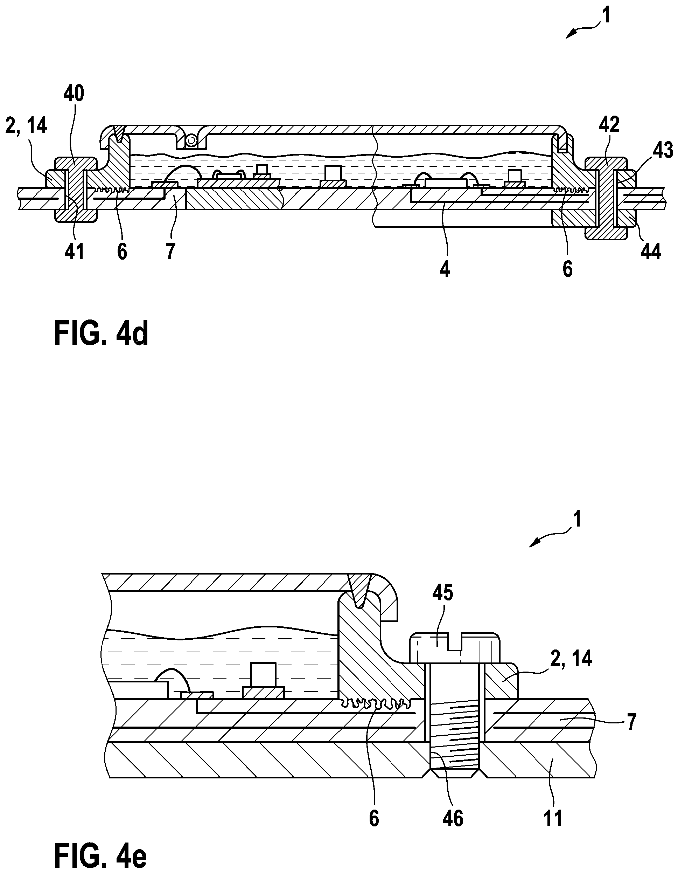

Weiter Bezug nehmend auf Figur 4d wird eine weitere exemplarische Ausführungsform eines erfindungsgemäßen Elektronikmoduls dargestellt.

Figur 4d entspricht hier im Wesentlichen dem Aufbau der Figur 4a mit einer geänderten bzw. zusätzlichen Befestigungsmöglichkeit des Mantelelementes 2 bzw. der Rahmenstruktur 14 am Leiterplattenelement 7 und/oder einem möglicherweise vorgesehenen Trägerelement 11. In Figur 4d ist das Rahmenelement 14 bzw. der aufgespritzte Gehäuserahmen durch mechanische Befestigungselemente mit dem Leiterplattenelement 7 verbunden. Geeignet hierfür sind beispielsweise Nietelemente 40, 42, die sich insbesondere außerhalb der Mikrostrukturierung 6 befinden und mit Bohrungen 41, 43 bzw. allgemein Öffnungen des Leiterplattenelementes 7 wechselwirken.

Diese Befestigungselemente können dabei auftretende Kräfte aufnehmen, insbesondere einen Großteil einer auftretenden Kraft im Vergleich zur Mikrostrukturierung 6 und diese dadurch entlasten. Somit könnten zum Beispiel Kräfte, welche durch unterschiedliche Temperaturausdehnungskoeffizienten von Mantelelement 2 und Leiterplattenelement 7 auftreten, aufgenommen werden, so dass die Mikrostrukturierung 6 im Wesentlichen nur eine Dichtfunktion übernehmen mag. Zusätzliche Befestigungselemente können somit eine Dichtfunktion mit höherer Sicherheit realisieren.

In Figur 4e ist, wie zuvor angedeutet, im Weiteren auch ein Trägerelement 11 vorgesehen. Das Befestigungselement in Figur 4e ist exemplarisch ein Schraubelement 45, das wiederum durch geeignete Öffnungen im Mantelelement 2 bzw. Rahmenelement 14 sowie Trägerelement 11 durchgreift. Ein metallisches Trägerelement 11 kann hierbei ein Gewinde aufweisen, mit welchem das Schraubelement 45 in Eingriff bringbar und somit befestigbar ist. Auch hier mag die Mikrostrukturierung 6 im Wesentlichen eine Dichtfunktion bereitstellen.

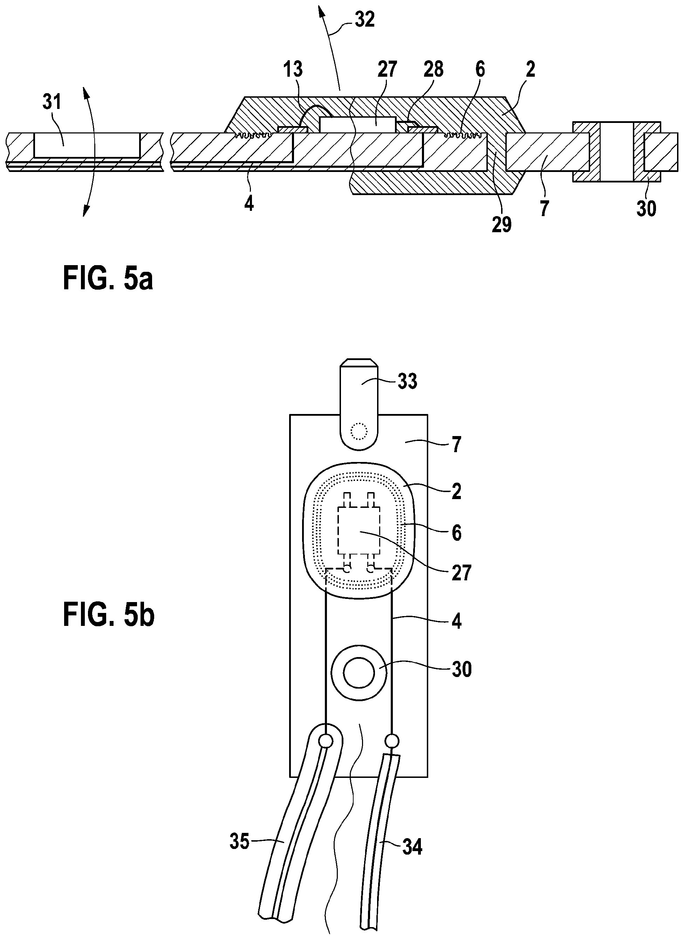

Die in den Figuren 5a und 5b gezeigten Ausgestaltungen eines Elektronikmoduls dienen illustrativen Zwecken und fallen nicht unter den beanpruchten Gegenstand. Figuren 5a,b zeigen eine Ausgestaltung feines Elektronikmoduls, bei dem ein Sensorelement direkt mit dem Mantelelement 2 eingegossen wird. Es stellt somit beispielsweise eine dichte ASIC-Umspritzung eines Sensors, beispielsweise eines Drehzahlsensors, dar.

Figur 5a stellt hierbei einen vereinfachten Sensoraufbau direkt auf dem Leiterplattenelement beispielsweise eines Steuergerätes dar. Der Sensor 27, beispielsweise ein ASIC (Application Specific Integrated Circuit), kann in geeigneter Weise direkt auf dem Leiterplattenelement 7 befestigt und durch Kontaktelemente 13, beispielsweise Bonds, oder auch direktes SMD-Löten 28 mit Leiterelementen 4 im Inneren des Leiterplattenelementes 7 verbunden sein. Die Mikrostrukturierung 6 auf der Oberfläche des Leiterplattenelementes 7 umläuft dabei das Sensorelement 27 sowie dessen Kontaktierung zumindest teilweise. Nachfolgend nach der Bestückung des Leiterplattenelementes 7 mit Sensorelement 27 kann durch eine Umspritzung mit einem Mantelelement 2 aus einem geeigneten Kunststoff wiederum eine dichte Verpackung des Sensorelementes 27 realisiert werden.

Je nach Ausgestaltung der Spritzwerkzeuge können im Weiteren bzw. beim selben Spritzvorgang weitere Funktionsbereiche auf dem bzw. im Leiterplattenelement 7 realisiert werden. Beispielsweise kann eine Kunststoffbefestigungsbuchse 30 angebracht werden.

Um den Sensorbereich des Elektronikmoduls gemäß Figur 5a in seine bevorzugte Sensorposition zu bringen, kann ein Bereich 31 des Leiterplattenelementes 7 teilflexibel ausgebildet sein. Hierdurch kann das Leiterplattenelement 7 verbogen und beispielsweise in Richtung 32 verschwenkt und befestigt werden. Je nach gewünschter Ausgestaltung kann das Material des Mantelelementes 2 das Leiterplattenelement zum Beispiel im Bereich 29 teilweise durchdringen und rückseitig formschlüssig umgreifen.

Auch Figur 5b zeigt ein erfindungsgemäßes Sensorelement 27 auf einem Leiterplattenelement 7 aufgebaut. Sensorelement 27 ist, vergleichbar mit Figur 5a, mit Leiterelementen 4 des Leiterplattenelementes 7 verbunden und im Bereich der Mikrostrukturierung 6 von einem Mantelelement 2 umschlossen.

Gleichzeitig mit dem Vergussvorgang des Mantelelementes 2 kann wiederum eine Befestigungsbuchse 30 sowie ein Zentrierzapfen 33 angespritzt werden. An geeigneter Stelle außerhalb des Mantelelementes 2 kann die externe Anbindung an das Sensorelement 27 beispielsweise über eine flexible Leiterplatte 35 oder aber über einen Kabelleiter 34, welcher beispielsweise an das Leiterplattenelement angelötet sein kann, erfolgen.

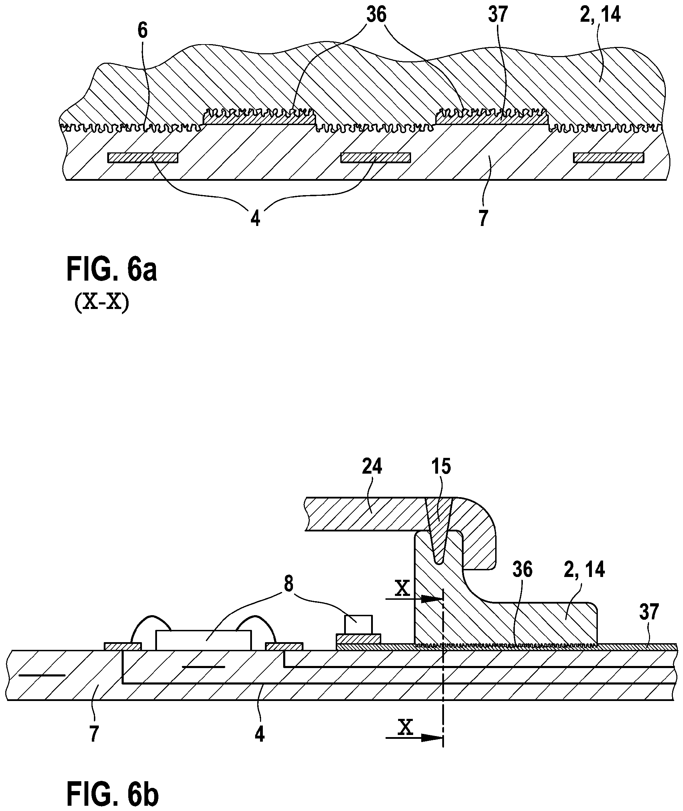

Figuren 6a,b zeigen ein Elektronikmodul mit dichter Moldverpackung direkt auf das Leiterplattenelement sowie an der Oberfläche befindliche Leiterelemente gespritzt.

Figur 6a zeigt ein Leiterplattenelement, bei dem sowohl die Oberfläche des Leiterplattenelementes 7 als auch sich auf der Oberfläche befindliche Leitelemente 37 mikrostrukturiert 6,36 sind. Der Strukturierungsprozess der umlaufenden Fläche kann wiederum beispielsweise durch Laserstrukturieren erfolgen. Die Laserleistung kann dabei während des Strukturierungsprozesses auf das jeweilige Material, beispielsweise Leiterplattenelement 7 oder Leiterelement 37, somit beispielsweise Kunststoff oder Metall, eingestellt werden, so dass beide Werkstoffe eine geeignete Mikrostrukturierung 6,36 erhalten. Ein im Nachfolgenden aufgebrachtes Mantelelement 2 kann somit nicht nur mit der Oberfläche des Leiterplattenelementes 7, sondern gleichfalls mit der mikrostrukturierten 36 Oberfläche des Leiterelementes 37 formschlüssig verbunden werden.

Hierbei stellt Figur 6a einen Schnitt X-X der Figur 6b dar. In einem nach der Mikrostrukturierung 6,36 erfolgten Umspritzprozess, bei dem exemplarisch, wie in Figur 6b dargestellt wurde, eine Rahmenstruktur 14 aufgebaut wurde, wird die Dichtheit zum Rahmenelement 14 sowohl über die Oberfläche des Leiterplattenelementes 6 als auch die Oberfläche des Leiterelementes 37, welches in Figur 6b exemplarisch an der Oberfläche des Leiterplattenelementes 7 verläuft, hergestellt.

Durch ein nachfolgend montiertes und gedichtetes Abdeckelement 24, wie zuvor beschrieben, wird der Innenraum des Elektronikmoduls gegenüber dem Außenbereich wiederum vollends dicht verschlossen, ein auf der Oberfläche angeordnetes Leiterelement 37 vermag jedoch Bauelemente 8 aus dem Innenraum des Elektronikmoduls mit dem Außenbereich elektronisch zu verbinden.

Die in den einzelnen Figuren dargestellten Einzelaspekte lassen sich selbstverständlich im Rahmen des erfinderischen Konzeptes frei mit allen Ausführungsbeispielen kombinieren.

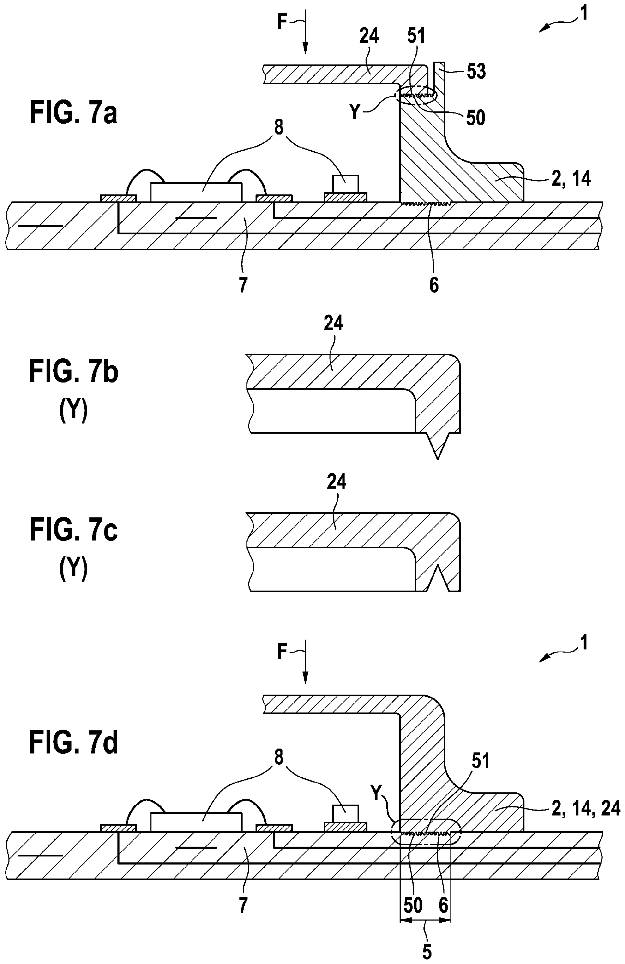

Die Figuren 7a-c zeigen eine weitere Ausführungsform eines erfindungsgemäßen Elektronikmoduls mit einem besonderen Aufbau von Rahmenelement 14 und Abdeckelement 24.

In dieser exemplarischen Ausgestaltung ist ein Abdeckelement 24 zum Beispiel aus thermoplastischem, teilkristallinem Kunststoff vorgesehen. Der Randbereich des Abdeckelementes 24 und/oder der Rahmenstruktur 14 kann mit einem geeigneten Heizelement aufgeschmolzen und die Elemente nachfolgend ineinandergelegt werden.

Gleichfalls denkbar ist, dass das Rahmenelement 14 seinerseits mikrostrukturiert 50 ist, so dass ein erwärmter Kunststoff des Abdeckelementes 24 einen Formschluss mit dieser Mikrostrukturierung 50 ausbildet 51. Das erwärmte Abdeckelement 24 wird im Bereich der Mikrostrukturierung 50 auf das Rahmenelement 14 gepresst bzw. unter Krafteinwirkung eingedrückt, wodurch sich in der Mikrostrukturierung 50 wiederum ein Formschluss zwischen Abdeckelement 24 und Rahmenstruktur 14 ergibt.

Für eine bessere Positionierung des Abdeckelementes 24 in X,Y-Richtung können außenliegend und insbesondere umlaufend am Rahmenelement 14 Stege 53 für einen Endanschlag vorgesehen sein, beispielsweise angespritzt sein.

Die Figuren 7b,c stellen dabei verschiedene Ausführungsformen des Randbereichs des Abdeckelementes 24 dar.

In Fig. 7d wiederum ist eine weitere exemplarische Ausgestaltung eines erfindungsgemäßen Elektronikmoduls mit einem Mantelelement dargestellt, welchen einen Hohlraum aufweist und direkt mit einer vorhandenen Mikrostrukturierung 6 auf einem Leiterplattenelement in Eingriff bringbar ist. Das Mantelelement 2 ist hierbei als einstückige Kombination des Rahmenelementes 14 zusammen mit einem Abdeckelelment 24 ausgeführt.

Das Mantelement 2 weist dabei einen Innenraum auf, in welchem wiederum elektronische Bauelemente 8 angeordnet sein können und kann z.B aus einem thermoplastischen Werkstoff gefertigt sein. Unter Verwendung eines geeigneten Heizelementes kann Mantelelement 2 im Bereich 5 aufgeschmolzen um im Anschluß in eine geeignete Mikrostruktur 6 gepresst bzw. unter Krafteinwirkung F eingedrückt zu werden. Hierdurch lässt sich wiederum ein Formschluss zwischen Mantelelement 2 und Leiterplattenelement 7 ausbilden 51.

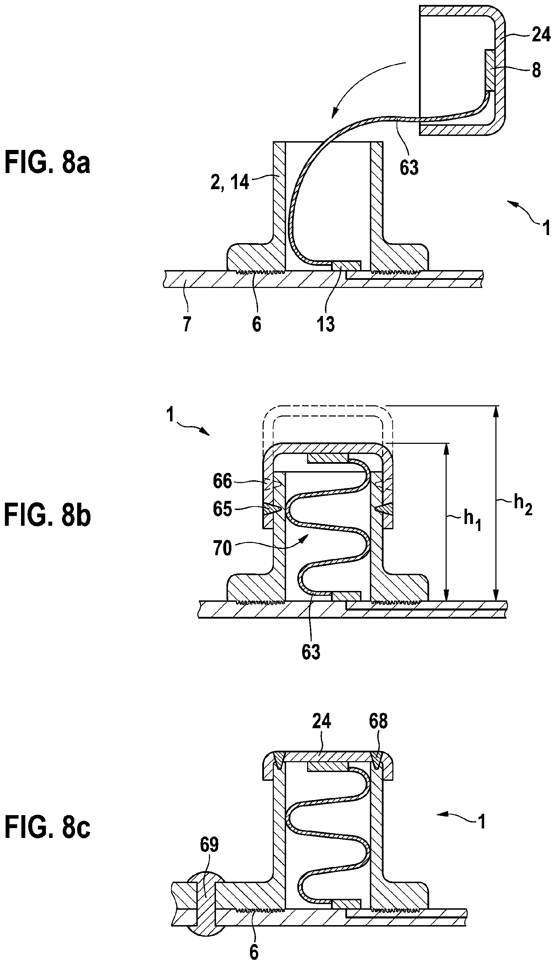

Weiter Bezug nehmend auf Figuren 8a-c wird eine weitere exemplarische Ausgestaltung eines erfindungsgemäßen Elektronikmoduls als Sensor dargestellt.

Figur 8a zeigt beispielsweise ein Sensorgehäuse, zum Beispiel einen Drehzahlsensor, welcher bevorzugt ein Rahmenelement 14 mit einer zylindrischen Ausgestaltung aufweist, das wiederum unter Verwendung einer Mikrostruktur 6 mit einem Leiterplattenelement 7 dicht verbunden ist.

Im ebenfalls zylindrisch ausgebildeten Abdeckelement 24 kann beispielsweise ein elektronisches Bauelement 8, zum Beispiel ein Sensor-ASIC angeordnet sein. Der Sensor 8 kann über ein elektrisches Verbindungselement 63, zum Beispiel ein Kabel oder eine flexible Leiterplatte, mit einem Kontaktpad 13, das sich auf dem Leiterplattenelement 7 befindet, in Verbindung stehen. Eine Anbindung des elektrischen Verbindungselementes 63 an Bauelement 8 und/oder Kontaktpad 13 kann insbesondere im in Figur 8a dargestellten, offenen Zustand des Elektronikmoduls 1 erfolgen. Nach erfolgter Montage kann das Abdeckelement 24 beispielsweise mit einer geringen Pressung auf das Rahmenelement 14 aufgepresst werden.

Figur 8b zeigt im Wesentlichen das auf das Rahmenelement 14 aufgepresste Abdeckelement 24. Ein Verschieben des Abdeckelementes 24 relativ zum Rahmenelement 14 ermöglicht ein Einstellen unterschiedlich resultierender Bauteilhöhen h₁, h₂ und ermöglicht somit das Realisieren unterschiedlicher Sensorhöhen bei prinzipiell gleichen Elektronikmodulkomponenten.

Das elektrische Verbindungselement 63 passt sich hierbei durch seine Verformbarkeit 70 sowie den im Inneren des Elektronikmoduls 1 zur Verfügungen stehenden Raum einer geforderten bzw. gewünschten Sensorhöhe h₁, h₂ an. Nachdem eine gewünschte Sensorhöhe durch geeignetes Aufschieben des Abdeckelementes 24 auf das Rahmenelement 14 ausgebildet wurde, kann die Sensorhöhe durch eine Fixierung 65, 66, zum Beispiel durch eine radiale Kunststoffschweißung, dichtend fixiert werden.

Figur 8c zeigt eine weitere exemplarische Ausgestaltung eines Sensorgehäuses, bei dem Abdeckelement 24 bezüglich seinen Seiten kürzer ausgeführt ist als beispielsweise in Figur 8a, b. Eine noch immer dichte Anbindung kann z.B. durch eine K-Laserschweißung 68 axial auf der Planseite des Abdeckelementes 24 erfolgen.

Auch kann wiederum eine zusätzliche Befestigung über ein mechanisches Befestigungselement 69, zum Beispiel eine Niete, erfolgen, das mechanische Spannungen aufnimmt, so dass die Mikrostrukturierung 6 wiederum nur im Wesentlichen eine Dichtfunktion übernehmen muss.

## Patentansprüche

1. Elektronikmodul, aufweisend
ein Leiterplattenelement (7) mit zumindest einem elektronischen Bauelement (8); und
ein Mantelelement (2);
wobei das Mantelelement (2) zumindest teilweise formschlüssig mit dem Leiterplattenelement (7) verbunden ist;
wobei das zumindest eine elektronische Bauelement (8) zwischen Mantelelement (2) und Leiterplattenelement (7) angeordnet ist
wobei die formschlüssige Verbindung von Leiterplattenelement (7) und Mantelelement (2) unter Verwendung einer Mikrostrukturierung (6) des Leiterplattenelementes (7) bereitgestellt ist und wobei das Mantelelement (2, 14) einen Innenraum ausbildet und das zumindest eine elektronische Bauelement (8) im Innenraum angeordnet ist, wobei das Mantelelement (2) als ein Rahmenelement (14) ausgebildet ist und das Elektronikmodul ein Abdeckelement (24) aufweist, welches zusammen mit dem Rahmenelement (14) das Mantelelement (2) ausbildet und den Innenraum für das zumindest eine elektronische Bauelement (8) aufweist.

2. Elektronikmodul gemäß dem vorhergehenden Anspruch, wobei zumindest in einem Teil des Kontaktbereiches von Abdeckelement (24) und Rahmenelement (14) zumindest eines der beiden Elemente eine Mikrostrukturierung (50) aufweist.

3. Elektronikmodul gemäß Anspruch 1, wobei das Abdeckelement (24) höhenverschiebbar auf dem Rahmenelement (14) angeordnet ist

4. Elektronikmodul gemäß einem der vorhergehenden Ansprüche, wobei das zumindest eine elektronische Bauelement (8) im Innenbereich des Elektronikmoduls gegenüber dem Außenbereich des Elektronikmoduls abgedichtet angeordnet ist

5. Elektronikmodul gemäß einem der vorhergehenden Ansprüche, wobei das Leiterplattenelement zumindest ein auf der Oberfläche angeordnetes Leiterelement (37) aufweist, wobei das Leiterelement (37) zumindest teilweise mikrostrukturiert (6) ausgebildet ist

6. Steuergerät für ein Fahrzeug, aufweisend ein Elektronikmodul gemäß einem der vorhergehenden Ansprüche.

7. Fahrzeug, insbesondere Automobil, aufweisend ein Elektronikmodul gemäß einem der vorhergehenden Ansprüche und/oder ein Steuergerät gemäß Anspruch 6.

8. Verfahren zur Herstellung eines Elektronikmoduls, aufweisend die Schritte bereitstellen eines Leiterplattenelementes (7), aufweisend zumindest ein elektronisches Bauelement (8);
mikrostrukturieren (6) zumindest eines Teils der Oberfläche des Leiterplattenelementes (7);
aufbringen eines Mantelelementes (2) auf zumindest einen Teil der Oberfläche des Leiterplattenelementes (7) im Bereich (5) der Mikrostrukturierung (6);
wobei ein
Formschluss zwischen Mantelelement (2) und Leiterplattenelement (7) unter Verwendung der Mikrostrukturierung (6) ausgebildet wird, wobei das Mantelelement (2) einen Innenraum ausbildet und das zumindest eine elektronische Bauelement (8) im Innenraum angeordnet ist, wobei das Mantelelement (2) als ein Rahmenelement (14) ausgebildet wird und das Elektronikmodul ein Abdeckelement (24) aufweist, welches zusammen mit dem Rahmenelement (14) das Mantelelement (2) ausbildet und den Innenraum für das zumindest eine elektronische Bauelement (8) aufweist.

## Claims

1. Electronic module, comprising
a printed circuit board element (7) having at least one electronic component (8); and
a casing element (2);
wherein the casing element (2) is connected to the printed circuit board element (7) at least partially with a form fit;
wherein the at least one electronic component (8) is arranged between the casing element (2) and the printed circuit board element (7),
wherein the form-fitting connection between the printed circuit board element (7) and the casing element (2) is provided using microstructuring (6) of the printed circuit board element (7) and wherein the casing element (2, 14) forms an inner space and the at least one electronic component (8) is arranged in the inner space, wherein the casing element (2) is in the form of a frame element (14) and the electronic module has a cover element (24) which, together with the frame element (14), forms the casing element (2) and has the inner space for the at least one electronic component (8).

2. Electronic module according to the preceding claim, wherein, at least in part of the contact region between the cover element (24) and the frame element (14), at least one of the two elements has microstructuring (50).

3. Electronic module according to Claim 1, wherein the cover element (24) is arranged in a vertically displaceable manner on the frame element (14).

4. Electronic module according to one of the preceding claims, wherein the at least one electronic component (8) is arranged in a manner sealed off with respect to the outer region of the electronic module in the inner region of the electronic module.

5. Electronic module according to one of the preceding claims, wherein the printed circuit board element has at least one conductor element (37) arranged on the surface, wherein the conductor element (37) has an at least partially microstructured (6) form.

6. Control unit for a vehicle, comprising an electronic module according to one of the preceding claims.

7. Vehicle, in particular an automobile, comprising an electronic module according to one of the preceding claims and/or a control unit according to Claim 6.

8. Method for producing an electronic module, comprising the steps of
providing a printed circuit board element (7) having at least one electronic component (8);
microstructuring (6) at least part of the surface of the printed circuit board element (7);
applying a casing element (2) to at least part of the surface of the printed circuit board element (7) in the region (5) of the microstructuring (6);
wherein a form fit is formed between the casing element (2) and the printed circuit board element (7) using the microstructuring (6), wherein the casing element (2) forms an inner space and the at least one electronic component (8) is arranged in the inner space, wherein the casing element (2) is in the form of a frame element (14) and the electronic module has a cover element (24) which, together with the frame element (14), forms the casing element (2) and has the inner space for the at least one electronic component (8).

## Revendications

1. Module électronique, comportant
un élément de carte de circuit imprimé (7) muni d'au moins un composant électronique (8) ; et
un élément d'enveloppe (2) ;
l'élément d'enveloppe (2) étant relié au moins partiellement par complémentarité de formes à l'élément de carte de circuit imprimé (7) ;
l'au moins un composant électronique (8) étant disposé entre l'élément d'enveloppe (2) et l'élément de carte de circuit imprimé (7),
la liaison par complémentarité de formes de l'élément de carte de circuit imprimé (7) et de l'élément d'enveloppe (2) étant réalisée à l'aide d'une micro-structuration (6) de l'élément de carte de circuit imprimé (7) et l'élément d'enveloppe (2, 14) formant un espace intérieur et l'au moins un composant électronique (8) étant disposé dans l'espace intérieur, l'élément d'enveloppe (2) étant conçu comme un élément de cadre (14) et le module électronique comportant un élément de recouvrement (24) qui forme, conjointement avec l'élément de cadre (14), l'élément d'enveloppe (2) et qui comporte l'espace intérieur destiné à l'au moins un composant électronique (8).

2. Module électronique selon la revendication précédente, au moins dans une partie de la zone de contact de l'élément de recouvrement (24) et de l'élément de cadre (14), l'un au moins des deux éléments comportant une micro-structuration (50).

3. Module électronique selon la revendication 1, l'élément de recouvrement (24) étant disposé sur l'élément de cadre (14) de manière à pouvoir coulisser en hauteur.

4. Module électronique selon l'une des revendications précédentes, l'au moins un composant électronique (8) étant disposé de manière étanche dans la région intérieure du module électronique par rapport à la région extérieure du module électronique.

5. Module électronique selon l'une des revendications précédentes, l'élément de carte de circuit imprimé comportant au moins un élément conducteur (37) disposé sur la surface, l'élément conducteur (37) étant au moins partiellement micro-structuré (6).

6. Dispositif de commande d'un véhicule, comprenant un module électronique selon l'une des revendications précédentes.

7. Véhicule, en particulier automobile, comportant un module électronique selon l'une des revendications précédentes et/ou un dispositif de commande selon la revendication 6.

8. Procédé de fabrication d'un module électronique, le procédé comprenant les étapes suivantes :
fournir un élément de carte de circuit imprimé (7) comportant au moins un composant électronique (8) ;
effectuer une micro-structuration (6) d'au moins une partie de la surface de l'élément de carte de circuit imprimé (7) ;
appliquer un élément d'enveloppe (2) sur au moins une partie de la surface de l'élément de carte de circuit imprimé (7) dans la région (5) de la micro-structuration (6) ;
une liaison par complémentarité de formes étant réalisée entre l'élément d'enveloppe (2) et l'élément de carte de circuit imprimé (7) à l'aide de la micro-structuration (6), l'élément d'enveloppe (2) formant un espace intérieur et l'au moins un composant électronique (8) étant disposé dans l'espace intérieur, l'élément d'enveloppe (2) étant conçu comme un élément de cadre (14) et le module électronique comportant un élément de recouvrement (24) qui forme, conjointement avec l'élément de cadre (14), l'élément d'enveloppe (2) et qui comporte l'espace intérieur destiné à l'au moins un composant électronique (8).
